# EUROPEAN PATENT APPLICATION

(11) **EP 2 744 205 A1**
(43) Date of publication of application: **18.06.2014**
(21) Application number: 12836025.2
(22) Date of filing: 03.09.2012
(51) Int. Cl.: H04N 9/07, H01L 27/14

(54) **IMAGE PICKUP APPARATUS AND FILTER**

(30) Priority: 26.09.2011 JP 2011209622; 27.02.2012 JP 2012039687
(71) Applicant: Sony Corporation, Tokyo 108-0075 (JP)
(72) Inventor: HIGASHITSUTSUMI, Yoshihito, Tokyo 108-0075 (JP); MOGI, Hideaki, Tokyo 108-0075 (JP); OZAWA, Ken, Tokyo 108-0075 (JP); IWAMA, Jun, Tokyo 108-0075 (JP)
(74) Representative: Berryman, Robert Jan
(86) International application number: PCT/JP2012/072355
(87) International publication number: WO 2013/047097

(57) **Abstract**

This technique relates to an image-capturing device and filter capable of providing an image-capturing device capable of detecting infrared light or ultraviolet light and visible light at a time.

An image-capturing device 1A includes a lens system 20 and an image-capturing unit 10 upon which light having passed through the lens system 20 is incident, wherein the image-capturing unit 10 includes a plurality of first image-capturing elements 11 configured to receive light in a first wavelength band and a plurality of second image-capturing elements 12 configured to receive light in a second wavelength band which is different from the first wavelength band, and wherein the lens system 20 or the image-capturing unit 10 is provided with an optical element 30A so that the light in the first wavelength band of which light quantity is less than the light quantity of the light in the second wavelength band reaches the image-capturing unit.

## Description

### TECHNICAL FIELD

The present disclosure relates to an image-capturing device and a filter.

### BACKGROUND ART

A single-plate color solid-state image-capturing device such as a CCD image sensor and a CMOS image sensor has an image-capturing element constituted by a photoelectric conversion element and a color filter that is arranged above the photoelectric conversion element and is configured to pass red color, green color or blue color. In order to obtain information about color video image, visible light received by the photoelectric conversion element outputs, as a signal, visible light that has passed the color filter and is received by the photoelectric conversion element. On the other hand, in recent years, a single plate color solid state image-capturing device (for example, see JP 2008-091753 A) for detecting a component other than the visible light, i.e., infrared light, has been developed. A new application that could not be achieved by just detecting the visible light is now being considered. More specifically, for example, the visible light and the infrared light are detected at a time, and on the basis of information about the detected infrared light, the sensitivity is improved, or the effect of the infrared light leaking into the photoelectric conversion element for detecting the visible light is alleviated, or the movement of a person is detected by detecting the infrared light.

### CITATION LIST

### PATENT DOCUMENT

Patent Document 1: JP 2008-091753 A
Patent Document 2: JP 4-110803 A
Patent Document 3: JP 61-015491 A

### SUMMARY OF THE INVENTION

### PROBLEMS TO BE SOLVED BY THE INVENTION

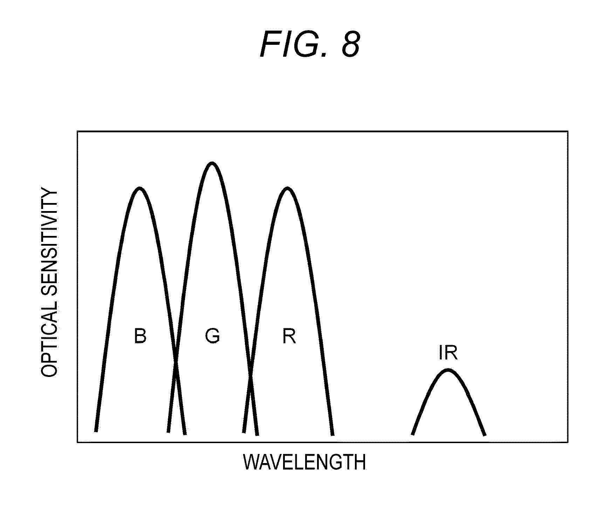

However, as schematically shown in Fig. 8, in an ordinary image-capturing device, the sensitivity of the photoelectric conversion element for detecting infrared light is lower than the sensitivity of the photoelectric conversion element for detecting visible light because of the characteristics of materials constituting the photoelectric conversion element. In Fig. 8, the horizontal axis indicates the wavelength of the light incident upon the photoelectric conversion element, and the vertical axis indicates the optical sensitivity of the photoelectric conversion element. Therefore, when the infrared light is to be sufficiently detected, there is a problem in that the photoelectric conversion element for detecting the visible light is saturated, and the image quality is reduced. In JP 2008-091753 A explained above, the configuration and the structure of the photoelectric conversion element for detecting the infrared light are configured to be different from the configuration and the structure of the photoelectric conversion element for detecting the visible light, so that the sensitivity of the photoelectric conversion element for the infrared light is improved. The configuration and the structure of the photoelectric conversion element suggested in JP 2008-091753 A is effective for making the sensitivity of the photoelectric conversion element for detecting the visible light and the sensitivity of the photoelectric conversion element for detecting the infrared light to be the same. However, the configuration and the structure of the photoelectric conversion element for detecting the infrared light and the configuration and the structure of the photoelectric conversion element for detecting visible light are preferably the same from the view point of manufacturing process of the image-capturing device.

A filter that passes the infrared light but does not pass the visible light is well-known as described in, for example, JP 4-110803 A, but when such filter is attached to an image-capturing device, it is impossible for the photoelectric conversion element to detect the visible light. A spectrum/filter device for introducing more blue color light than red color light and green color light into a photoelectric conversion element is well-known as described in, for example, JP 61-015491 A. Even when such spectrum/filter device is attached to an image-capturing device having photoelectric conversion elements for detecting the visible light and the infrared light, these photoelectric conversion elements cannot detect the infrared light and the visible light with the same level of sensitivity. It should be noted that, with regard to the relationship between the ultraviolet light and the visible light, there is the same problem as the above-described problem. More specifically, there is a problem in that the ultraviolet light and the visible light cannot be detected with the same level of sensitivity.

Therefore, an object of the present disclosure is to provide an image-capturing device capable of detecting infrared light or ultraviolet light and visible light in the same manner and to provide a filter suitable for use with such image-capturing device.

### SOLUTIONS TO PROBLEMS

An image-capturing device according to the present disclosure for achieving the above-described object includes a lens system and an image-capturing unit upon which light having passed through the lens system is incident, wherein the image-capturing unit includes a plurality of first image-capturing elements configured to receive light in a first wavelength band and a plurality of second image-capturing elements configured to receive light in a second wavelength band which is different from the first wavelength band, and wherein an optical element is provided so that the light in the first wavelength band of which light quantity is less than the light quantity of the light in the second wavelength band reaches the image-capturing unit.

A filter according to a first aspect of the present disclosure for achieving the above-described object includes a first region having an external shape in a circular or regular polygonal shape and a second region in a ring shape encircling the first region, wherein the first region passes light in a first wavelength band and light in the second wavelength band which is different from the first wavelength band, and in the second region, an optical transmittance rate of the light in the first wavelength band is lower than the optical transmittance rate of the light in the second wavelength band.

A filter according to a second aspect of the present disclosure for achieving the above-described object that passes light in a first wavelength band and light in the second wavelength band which is different from the first wavelength band, and in the second region, an optical transmittance rate of the light in the first wavelength band is lower than the optical transmittance rate of the light in the second wavelength band.

### EFFECTS OF THE INVENTION

The image-capturing device according to the present disclosure is provided with an optical device so that the light in the first wavelength band of which light quantity is less than the light quantity of the light in the second wavelength band reaches the image-capturing unit. According to the filter according to the aspect 1 of the present disclosure, in the second region, the optical transmittance rate of the light in the first wavelength band is less than the optical transmittance rate of the light in the second wavelength band. Further, in the filter according to the second aspect of the present disclosure, the optical transmittance rate of the light in the first wavelength band is less than the optical transmittance rate of the light in the second wavelength band. Therefore, as the entire optical element, or, as the entire filter, more light in the second wavelength band reaches the image-capturing unit, and less light in the first wavelength band reaches the image-capturing unit. As a result, the image-capturing unit can detect the light in the first wavelength band and the light in the second wavelength band with the same level of sensitivity. It should be noted that the image-capturing device is usually provided with an IR-cut filter for cutting the infrared light having an undesired wavelength, but according to the filter according to the second aspect of the present disclosure, although depending on the configuration, the structure, the arrangement, the IR-cut filter can be replaced, and in this case, it is not necessary to greatly change the design of the image-capturing device or greatly change the manufacturing steps of the image-capturing device.

### BRIEF DESCRIPTION OF DRAWINGS

Figs. 1(A) and 1(B) are a schematic view illustrating an image-capturing device according to Example 1 and a schematic sectional view illustrating a filter according to Example 1, respectively, and Fig. 1C is a schematic sectional view illustrating a filter according to Example 2.
Figs. 2(A) and 2(B) are a figure schematically illustrating an arrangement of image-capturing elements in an image-capturing unit of the image-capturing device according to Example 1 and a partial schematic sectional view illustrating a first image-capturing element, respectively.
Figs. 3(A) and 3(B) are a schematic view illustrating a conceptual diagram illustrating an image-capturing device according to Example 3 and a schematic sectional view illustrating a filter according to Example 3, respectively.
Figs. 4(A), 4(B), and 4(C) are a schematic view illustrating an image-capturing device according to Example 5, a schematic sectional view illustrating a filter according to Example 5, and a schematic front view illustrating a filter according to Example 5, respectively, and Fig. 4(D) is a schematic sectional view illustrating a filter according to Example 6.
Fig. 5 is a schematic view illustrating an image-capturing device according to Example 8.
Figs. 6(A), 6(B), and 6(C) are figures schematically illustrating an optical transmittance rate of the filter according to Example 1, an optical transmittance rate of an IR-cut filter, and an optical transmittance rate of a combination of the IR-cut filter and the filter according to Example 1.
Figs. 7(A), 7(B), and 7(C) are figures schematically illustrating an optical transmittance rate of the filter according to Example 4, an optical transmittance rate of an UV-cut filter, and an optical transmittance rate of a combination of the UV-cut filter and the filter according to Example 4.
Fig. 8 is a schematic view indicating that the sensitivity of the photoelectric conversion element for detecting the infrared light is lower than the sensitivity of the photoelectric conversion element for detecting the visible light.

### MODES FOR CARRYING OUT THE INVENTION

Hereinafter, the present disclosure will be explained on the basis of Examples with reference to drawings, but the present disclosure is not limited to the Examples. Numerical values and materials are merely examples in the Examples. Explanation will be made in the following order.
1. Overall explanation about an image-capturing device according to the present disclosure and a filter according to first aspect and the second aspect of the present disclosure
2. Example 1 (an image-capturing device according to the present disclosure and a filter according to the aspect 1 of the present disclosure)
3. Example 2 (a modification of Example 1)
4. Example 3 (another modification of Example 1)
5. Example 4 (still another modification of Example 1)
6. Example 5 (an image-capturing device according to the present disclosure and a filter according to the second aspect of the present disclosure)
7. Example 6 (a modification of Example 5)
8. Example 7 (another modification of Example 5)
9. Example 8 (a modification of Example 1 to Example 7)
10. Example 9 (a modification of Example 1 to Example 8), and others

### [Overall explanation about an image-capturing device according to the present disclosure and a filter according to the first aspect and the second aspect of the present disclosure]

When an optical element in an image-capturing device according to the present disclosure is constituted by a filter, or in a case of a filter according to the first aspect or the second aspect of the present disclosure, the filter may be configured to be made of a filter base material and a filter material layer formed on the filter base material, or, for example, a filter material may be kneaded into a filter base material or dispersed therein. In the former case, "the material of the filter" means a material constituting the filter material layer (filter material). In the latter case, "the material of the filter" means a material kneaded into the filter base material or dispersed therein (filter material). Alternatively, the filter may be configured to be made of a filter base material and a filter structure layer (for example, dielectric multi-layer film) formed on the filter base material.

In the image-capturing device according to the present disclosure, a peak wavelength in a first wavelength band may be configured to be shorter than a peak wavelength in a second wavelength band. Alternatively, the peak wavelength in the first wavelength band may be configured to be longer than the peak wavelength in the second wavelength band. In the former case, the first wavelength band corresponds to a visible light band, and the second wavelength band corresponds to an infrared light band. On the other hand, in the latter case, the first wavelength band corresponds to a visible light band, and the second wavelength band corresponds to an ultraviolet light band.

In such preferred modes of the image-capturing device according to the present disclosure, an optical element may be made of a filter; and in the filter, the optical transmittance rate of the light in the first wavelength band may be configured to be lower than the optical transmittance rate of the light in the second wavelength band. It should be noted that, when the material constituting the filter is appropriately selected, i.e., when the filter is made of a material in which the optical transmittance rate of the light in the first wavelength band is less than the optical transmittance rate of the light in the second wavelength band, the optical transmittance rate of the light in the first wavelength band can be configured to be lower than the optical transmittance rate of the light in the second wavelength band. It should be noted that, for the sake of convenience, the image-capturing device of such configuration may be referred to as "the image-capturing device A-1 according to the present disclosure" in some cases. Alternatively, the filter may be constituted by a dielectric multi-layer film, so that the optical transmittance rate of the light in the first wavelength band can be configured to be lower than the optical transmittance rate of the light in the second wavelength band. It should be noted that, for the sake of convenience, the image-capturing device of such configuration may be referred to as "the image-capturing device A-2 according to the present disclosure." In the image-capturing device A-2 according to the present disclosure, it may be a filter for cutting light of an undesired wavelength in the second wavelength band. For the sake of convenience, the image-capturing device A-1 according to the present disclosure and the image-capturing device A-2 according to the present disclosure may be collectively referred to as "the image-capturing device A according to the present disclosure."

In the filter according to the second aspect of the present disclosure, the optical transmittance rate of the light in the first wavelength band is lower than the optical transmittance rate of the light in the second wavelength band, but the filter according to the second aspect of the present disclosure is also such that, when the material constituting the filter is appropriately selected, i.e., the filter is made of a material in which the optical transmittance rate of the light in the first wavelength band is lower than the optical transmittance rate of the light in the second wavelength band, the optical transmittance rate of the light in the first wavelength band can be configured to be lower than the optical transmittance rate of the light in the second wavelength band. For the sake of convenience, the filter having such configuration may be referred to as "the filter according to the aspect 2-1 of the present disclosure' in some cases. Alternatively, the filter may be constituted by a dielectric multi-layer film, so that the optical transmittance rate of the light in the first wavelength band can be configured to be lower than the optical transmittance rate of the light in the second wavelength band. It should be noted that, for the sake of convenience, the filter having such configuration may be referred to as "the filter according to the aspect 2-2 of the present disclosure" in some cases. In the filter according to the aspect 2-2 of the present disclosure, it may be a filter for cutting light of an undesired wavelength in the second wavelength band.

In this case, in the image-capturing device A according to the present disclosure or the filter according to the second aspect of the present disclosure, an average optical transmittance rate for a wavelength equal to or more than 400 nm and less than 650 nm in the first wavelength band may be more than 0% and equal to or less than 80%, and an average optical transmittance rate in the second wavelength band may be equal to or more than 80%. For example, the wavelength in the second wavelength band is 650 nm to 1200 nm, or less than 400 nm. In the image-capturing device A-1 according to the present disclosure or the filter according to the aspect 2-1 of the present disclosure including such preferred configuration, the filter may be configured to be formed by laminating a red color transmission layer that is configured to transmit the red color and a blue color transmission layer that is configured to transmit the blue color. It should be noted that, in this case, the filter has spectral characteristics like magenta. Alternatively, the filter may be configured to be formed by laminating a red color transmission layer that is configured to transmit the red color, a green color transmission layer that is configured to transmit the green color, and a blue color transmission layer that is configured to transmit the blue color. More specifically, the red color transmission layer may be made of the same material as a color filter for configured to transmit the red color that is provided above a photoelectric conversion element constituting the image-capturing element (red color filter material), and the green color transmission layer may be made of the same material as a color filter for configured to transmit the green color that is provided above a photoelectric conversion element constituting the image-capturing element (green color filter material), and the blue color transmission layer may be made of the same material as a color filter for configured to transmit the blue color that is provided above a photoelectric conversion element constituting the image-capturing element (blue color filter material). In a filter having such structure in which the red color transmission layer and the blue color transmission layer are laminated or a structure in which the red color transmission layer, the green color transmission layer, and the blue color transmission layer are laminated, the filter in which the optical transmittance rate of the light in the first wavelength band is lower than the optical transmittance rate of the light in the second wavelength band can be made by appropriately selecting the material (color filter material) and the layer thicknesses of the red color transmission layer, the green color transmission layer, and the blue color transmission layer. In the filter having such configuration, the red color transmission layer, the green color transmission layer, and the blue color transmission layer are not constituted by a multi-layer film interference filter made by laminating thin films, and therefore, dependency upon incidence angle of the light onto the filter can be alleviated. Materials constituting the filter base material for forming, thereon, the laminated layer structure including the red color transmission layer, the green color transmission layer, and the blue color transmission layer include optical glass and transparent resin. Alternatively, the filter may be constituted by a material in which the filter base material also functions as the filter material. Alternatively, in the image-capturing device A-1 according to the present disclosure or the filter according to the aspect 2-1 of the present disclosure that has the preferred configuration that has been described above, the filter may be constituted by an electrochromic material layer that is sandwiched by two transparent electrodes or graphene electrodes. Alternatively, the filter may be constituted by a liquid crystal material layer that is sandwiched by two transparent electrodes or graphene electrodes. With such configuration, the optical transmittance rate of the light that passes through the electrochromic material layer or the liquid crystal material layer can be controlled by controlling the voltage that is applied to the electrodes. Alternatively, in the image-capturing device A-2 according to the present disclosure or the filter according to the aspect 2-2 of the present disclosure that has the preferred configuration that has been described above, the filter may be constituted by a dielectric multi-layer film, as explained previously. In this case, examples of high refractive index materials include TiO₂, Ta₂O₅, Nb₂O₅, Si₃N₄, and the like, and examples of refractive index materials include SiO₂, MgF₂, and the like.

Further, in the image-capturing device A-1 according to the present disclosure or the filter according to the aspect 2-1 of the present disclosure having various kinds of preferred configuration that has been described above, the filter may be configured to be attached to a front surface portion of a lens system. The filter may be attached to the front surface portion of the lens system on the basis of well-known methods such as screwing with the front surface portion of the lens barrel. However, the attachment of the filter to the lens system is not limited to those methods. Alternatively, the filter may be configured to be arranged adjacent to a diaphragm unit provided in the lens system. In such case, in the image-capturing unit, an IR-cut filter for cutting the infrared light having an undesired wavelength is preferably arranged. On the other hand, the image-capturing device A-2 according to the present disclosure or the filter according to the aspect 2-2 of the present disclosure having various kinds of preferred configuration that has been explained above may be arranged in any portion of the lens system. For example, the image-capturing device A-2 according to the present disclosure or the filter according to the aspect 2-2 of the present disclosure having various kinds of preferred configurations that have been explained above may be attached to a front surface portion of the lens system, or may be arranged adjacent to the diaphragm unit provided in the lens system, or when the filter is constituted by a dielectric multi-layer film for cutting the infrared light having an undesired wavelength, and in addition, this filter is arranged in the image-capturing unit, then, a conventional IR-cut filter for cutting the infrared light having an undesired wavelength is not required.

Alternatively, in the above-described preferred modes, the optical element may be made of a filter, and the filter may include a first region having an external shape such as a circular shape and a regular polygonal shape and a second region in a ring shape that encircles the first region, wherein the first region passes the light in the first wavelength band and the second wavelength band, and in the second region, the optical transmittance rate of the light in the first wavelength band may be configured to be lower than the optical transmittance rate of the light in the second wavelength band. It should be noted that, for the sake of convenience, the image-capturing device configured as described above will be referred to as "the image-capturing device B according to the present disclosure."

In the image-capturing device B according to the present disclosure or the filter according to the first aspect of the present disclosure, the optical transmittance rate of the light in the first wavelength band may be configured to gradually decrease from the portion of the second region at the border between the first region and the second region to the external periphery of the second region. In such configuration, the diffraction of the light at the border between the first region and the second region can be alleviated, and the reduction of the MTF (Modulation Transfer Function) in the first wavelength band of the lens system can be prevented. It should be noted that gradual reduction of the optical transmittance rate of the light in the first wavelength band can be represented by, for example, Gaussian function.

In the image-capturing device B according to the present disclosure or the filter according to the first aspect of the present disclosure having the above-described preferred configuration, the filter may be constituted by an apodization filter. It should be noted that the configuration of the apodization filter may be a well-known configuration. Alternatively, the configuration of the apodization filter may be the following configuration: the second region is made by laminating the red color transmission layer that is configured to transmit the red color and the blue color transmission layer that is configured to transmit the blue color, and the thickness of the red color transmission layer and the thickness of the blue color transmission layer gradually become thicker from the portion of the second region at the border between the border between the first region and the second region to the external periphery of the second region. Alternatively, the configuration of the apodization filter may be the following configuration: the second region is made by laminating the red color transmission layer that is configured to transmit the red color, the blue color transmission layer that is configured to transmit the green color, and the blue color transmission layer that is configured to transmit the blue color, wherein the thickness of the red color transmission layer, the thickness of the green color transmission layer, and the thickness of the blue color transmission layer gradually become thicker from the portion of the second region at the border between the first region and the second region to the external periphery of the second region. More specifically, the red color transmission layer, the green color transmission layer, and the blue color transmission layer may be constituted by the color filter materials explained above, and the material constituting the filter base material may be constituted by the materials explained above.

Further, in the image-capturing device B according to the present disclosure or the filter according to the first aspect of the present disclosure that has the preferred configuration that has been described above, the size of the first region may be configured to be variable. In order to make the size of the first region to be variable, for example, the filter may have the same structure as a so-called diaphragm blade, and in this case, the diaphragm blade constituting the filter may be manufactured by, for example, a material constituting the filter base materials explained above. It should be noted that the filter material layer may be formed on one of the surfaces of the diaphragm blade constituting the filter. Alternatively, the filter may be constituted by a material in which the filter base material also functions as the filter material. Further, when the filter having such configuration that the size of the first region is variable, the depth of the field can be deepened in the first wavelength band. Alternatively, in the image-capturing device B according to the present disclosure or the filter according to the first aspect of the present disclosure, the filter may be constituted by an electrochromic material layer that is sandwiched by two transparent electrodes or graphene electrodes, or may be constituted by a liquid crystal material layer that is sandwiched by two transparent electrodes or graphene electrodes, and in such configuration, the optical transmittance rate of the light passing through the electrochromic material layer or the liquid crystal material layer can be controlled and the size of the first region can be controlled by controlling the voltage that is applied to the electrodes. Alternatively, in the image-capturing device B according to the present disclosure or the filter according to the first aspect of the present disclosure, the filter may be constituted by the dielectric multi-layer film in the same manner as what has been described above.

Further, in the image-capturing device B according to the present disclosure or the filter according to the first aspect of the present disclosure that has the preferred configuration that has been described above, the filter may be configured to be arranged adjacent to the diaphragm unit provided in the lens system. In this case, an IR-cut filter for cutting the infrared light having an undesired wavelength is preferably arranged in the image-capturing unit.

Further, in the image-capturing device B according to the present disclosure or the image-capturing device A according to the present disclosure including the preferred configuration that has been explained above, the filter may be configured to be arranged detachably to/from the lens system. In this case, in order to detachably arrange the filter detachably to/from the lens system, for example, the following configuration and structure may be used: a member having not only the filter and but also an aperture in the lens system may be attached to a rotation shaft in such a manner that it can rotate about the rotation shaft that is parallel to the optical axis of the lens system, and the member is rotated about the rotation shaft, whereby the optical line passing through the lens system passes through the aperture, or passes through the filter. Alternatively, the following configuration and structure may be used: in the lens system, a member having not only the filter and but also an aperture is, for example, attached to the lens system in such a manner that it can freely slide in a direction perpendicular to the optical axis of the lens system, and such member is caused to slide, whereby the optical line passing through the lens system passes through the aperture, or passes through the filter. In this case, the member having not only the filter and but also the aperture may be constituted by one member or may be constituted by multiple pieces of members. The infrared light absorption filter may be provided on the aperture. Alternatively, when the filter is detached from the lens system, for example, as necessary, the infrared light absorption filter may be screwed into the front surface portion of the lens barrel, so that the infrared light incident upon the image-capturing unit may be cut.

Further, in the image-capturing device according to the present disclosure including the image-capturing device A or the image-capturing device B according to the present disclosure including the preferred configuration and the mode that has been explained above, the first image-capturing element may be in a mode constituted by an image-capturing element unit including a red color image-capturing element, a green color image-capturing element, and a blue color image-capturing element in order to obtain color images with the image-capturing device, and in this case, one pixel may be configured to be made up with one image-capturing element unit and one second image-capturing element, i.e., one pixel may be configured to be made up with four image-capturing elements. It should be noted that the second image-capturing element is constituted by an infrared light image-capturing element for detecting the infrared light. Alternatively, it should be noted that the second image-capturing element is constituted by an ultraviolet light image-capturing element for detecting the ultraviolet light. An example of a mode of arrangement of image-capturing elements in a case where one pixel is constituted by one image-capturing element unit and a piece of second image-capturing element includes a Bayer arrangement. In this case, for the sake of convenience, one pixel constituted by four image-capturing elements will be referred to as "infrared light/ultraviolet light-sensitive image-capturing element unit." For the sake of convenience, a pixel having the Bayer arrangement and constituted by one red color image-capturing element, two green color image-capturing elements, and one blue color image-capturing element will be referred to as "visible light-sensitive image-capturing element unit." An image-capturing unit may be constituted by infrared light/ultraviolet light-sensitive image-capturing element units arranged in a two-dimensional matrix form. Alternatively, the following configuration may be employed: one row of infrared light/ultraviolet light-sensitive image-capturing element units may be arranged, and one row or multiple rows of visible light-sensitive image-capturing element units may be arranged adjacent to this row. Alternatively, the following configuration may be employed: the infrared light/ultraviolet light-sensitive image-capturing element units may be arranged in a lattice form (shape of parallel crosses), and in the remaining region, the visible light-sensitive image-capturing element unit may be arranged. Alternatively, the following configuration may be employed: the infrared light/ultraviolet light-sensitive image-capturing element units may be arranged on the crossing points of the lattice, and in the remaining region, the visible light-sensitive image-capturing element unit may be arranged. The mode of arrangement of the image-capturing elements is not limited to the Bayer arrangement. Alternatively, examples of arrangements of the image-capturing elements include an interline arrangement, a G stripe RB checkered arrangement, a G stripe RB complete checkered arrangement, a checkered complementary color arrangement, a stripe arrangement, a diagonal stripe arrangement, a primary color color difference arrangement, a field color difference sequential arrangement, a frame color difference sequential arrangement, a MOS-type arrangement, an improved MOS-type arrangement, a frame interleave arrangement, a field interleave arrangement, and the like.

Alternatively, in the image-capturing device according to the present disclosure including the image-capturing device A or the image-capturing device B according to the present disclosure including the preferred configuration and mode that has been explained above, one pixel may be configured to be constituted by one image-capturing element unit and one piece of second image-capturing element in order to obtain black/white (gray) image with the image-capturing device.

Further, in the image-capturing device according to the present disclosure including the image-capturing device A or the image-capturing device B according to the present disclosure including the preferred configuration and mode that has been explained above, the image-capturing device may be configured to be further provided with an illumination device that emits light in the second wavelength band, and in this case, the light in the second wavelength band that is emitted by the illumination device may be configured to include one or multiple peak wavelengths. In a case where the light in the second wavelength band that is emitted by the illumination device includes multiple peak wavelengths (for example, N peak wavelengths), the light source constituting the illumination device may be N types of light sources, for example, N types of LEDs of which light emission peak wavelengths are different from each other. The illumination device is caused to emit light N times, and image-capturing process is performed N times with the lights in the second wavelength band of which peak wavelengths are different, or although depending on the optical transmittance rate characteristics of the filter, the illumination device is caused to emit light once, and N types of LEDs are caused to emit light at a time, and the image-capturing process is performed once using the lights in the second wavelength band of which peak wavelengths are different, so that the second image-capturing element can obtain N types of image data, and various kinds of information can be obtained by analyzing these N types of image data. The optical transmittance rate of the light of the optical element in the second wavelength band may be optimized in accordance with the light source. More specifically, in accordance with N types of light sources, the optical transmittance rate of the light in the second wavelength band in the optical element may be optimized, and the ratio of the optical transmittance rate for the lights from the N types of light sources may be optimized, and the optical spectrum may be optimized. All of multiple light sources may be light sources that emit the infrared light, or all of multiple light sources may be light sources that emit the ultraviolet light, or there may be both of the light sources for emitting the infrared light and the light sources for emitting the ultraviolet light in a mixed manner. It should be noted that, although depending on the light emission intensity of the illumination device, an optical element in which the optical transmittance rate of the light in the first wavelength band is lower than the optical transmittance rate of the light in the second wavelength band may be preferred, or an optical element in which the optical transmittance rate of the light in the first wavelength band is higher than the optical transmittance rate of the light in the second wavelength band may be preferred. The optical element may be exchanged in a case where the illumination device is used and in a case where the illumination device is not used, or multiple optical elements may be used depending on cases.

In the filter of the image-capturing device according to the present disclosure, the light in the first wavelength band is caused to reach the image-capturing unit, and therefore the optical transmittance rate of the light in the first wavelength band at the filter has a value more than 0%. The filter according to the second aspect of the present disclosure passes the light in the first wavelength band, and therefore, the optical transmittance rate of the light in the first wavelength band has a value more than 0%.

In the image-capturing device A according to the present disclosure or the filter according to the second aspect of the present disclosure, the light reduction coefficient for the light in the first wavelength band is defined as V, the sensitivity maximum value of the second image-capturing element is defined as D₂, and the saturation level of the first image-capturing element when the luminous flux corresponding to the sensitivity maximum value D₂ of the second image-capturing element is incident upon the first image-capturing element is defined as X₁ (unit: lux). In this case, the light reduction coefficient V may be set so as to satisfy V ≤ X₁/D₂. When the AE target setting value of the automatic exposure mechanism of the image-capturing device is 1/Y₁ with respect to the saturation level X₁ of the first image-capturing element, the AE target setting value may be configured to be (V/Y₁) or less, and the lower limit value of "V" depends on the dynamic range setting of the image-capturing device.

In the image-capturing device B according to the present disclosure or the filter according to the first aspect of the present disclosure, when the external shape of the first region is in a regular polygonal shape, examples of regular polygonal shapes include a regular pentagonal shape, a regular hexagonal shape, a regular heptagonal shape, and a regular octagonal shape. It should be noted that the regular polygonal shape includes quasi-regular polygonal shapes (a regular polygonal shape each side of which is constituted by a curved line, a regular polygonal shape of which vertex is round). Further, the optical transmittance rate of the light in the first wavelength band in the second region is lower than the optical transmittance rate of the light in the second wavelength band in the second region, but he optical transmittance rate of the light in the first wavelength band in the second region also includes 0%. The first region may be constituted by the aperture portion. The second region may be constituted by the laminated structure including the red color transmission layer and the blue color transmission layer explained above, the laminated structure including the red color transmission layer, the green color transmission layer, and the blue color transmission layer, a dielectric multi-layer film, and a well-known filter material available in the market for cutting the visible light. Further, when the second wavelength band is the infrared light, the UV-cut filter may be arranged in the second region, and when the second wavelength band is the ultraviolet light, the IR-cut filter may be arranged in the second region. Materials constituting the filter base material for forming the second region thereon include those material explained above, or the filter may be constituted by such materials that the filter base material also functions as the filter material.

The image-capturing device according to the present disclosure may include an image processing unit, and this image processing unit may include a first gain adjustment unit configured to adjust the output from the first image-capturing element and a second gain adjustment unit configured to adjust the output from the second image-capturing element. This can easily achieve brightness adjustment of an image obtained by the first image-capturing element and an image obtained by a second image-capturing element. In this case, where the adjustment coefficient by the first gain adjustment unit on the output given by the first image-capturing element is Gn₁, and the adjustment coefficient by the second gain adjustment unit on the output given by the second image-capturing element is Gn₂, it is preferable to satisfy Gn₁/Gn₂ ≥ 1. The value of (Gn₁/Gn₂) may be, for example, specifically, 2, 4, 8, and the like. In such mode, when the light quantity of the light in the first wavelength band reaching the first image-capturing element decreases, and the difference from the light quantity of the light in the second wavelength band reaching the second image-capturing element greatly changes, this can reduce the difference in the brightness between the image obtained by the first image-capturing element and the image obtained by the second image-capturing element. The light quantity of the light in the first wavelength band reaching the first image-capturing element decreases, and in accordance with the difference of the light quantity of the light in the second wavelength band reaching the second image-capturing element, the adjustment coefficients Gn₁, Gn₂ can be automatically or manually changed. The adjustment of the output from, for example, the red color image-capturing element, the green color image-capturing element, and the blue color image-capturing element with the first gain adjustment unit can be the same, and in some cases, the adjustment of the output from, for example, the red color image-capturing element, the green color image-capturing element, and the blue color image-capturing element with the first gain adjustment unit may be different.

In order for the light other than the light in the first wavelength band and the light in the second wavelength band not to reach the first image-capturing element and the second image-capturing element, the image-capturing unit is configured such that, in order to prevent occurrence of mixing of color in terms of light and exclude undesired environmental light and the like, a filter for cutting the light other than the light in the first wavelength band and the light in the second wavelength band may be arranged in the lens system, or may be arranged in the first image-capturing element and the second image-capturing element as necessary. When the second wavelength band is the infrared light, the UV-cut filter may be arranged in the lens system, and when the second wavelength band is the ultraviolet light, the IR-cut filter may be arranged in the lens system. Alternatively, as described above, the IR-cut filter for cutting the infrared light having an undesired wavelength may be arranged in the lens system or the image-capturing unit. The optical transmittance rate of the light in the first wavelength band and the optical transmittance rate of the light in the second wavelength band may be determined on the basis of the ratio in the sensitivity between the light in the first wavelength band and the light in the second wavelength band in the semiconductor substrate or the semiconductor layer provided with the photoelectric conversion element constituting the image-capturing element. For example, when the ratio in the sensitivity between the first image-capturing element and the second image-capturing element is α : 1, the ratio in the optical element between the optical transmittance rate of the light in the first wavelength band and the optical transmittance rate of the light in the second wavelength band may be (1/α) : 1, but the ratio is not limited thereto. With the optical element provided in the lens system, the light in the first wavelength band of which light quantity is less than the light quantity of the light in the second wavelength band reaches the image-capturing unit. In other words, the optical transmittance rate of the optical element may be set and/or the adjustment coefficients Gn₁, Gn₂ may be controlled, so that the output value from the first image-capturing element is about the same as the output value from the second image-capturing element (more specifically, although not limited thereto, the ratio of [the output value from the first image-capturing element/the output value from the second image-capturing element] becomes, for example, 0.5 to 2). When the light quantity of the light incident upon the image-capturing unit is insufficient, and it is necessary to increase the light exposure time (exposure time), it is preferable to control the adjustment coefficients Gn₁, Gn₂, instead of increasing the exposure time, from the view point of not causing blur in the image of the subject that has been captured as the image. The light exposure time (exposure time) is preferably, for example, 0.1 seconds or less. The spectrum of the optical element in the first wavelength band may not be necessarily flat. Multiple optical elements of which characteristics are different (for example, optical elements of which optical transmittance rates are different) may be prepared, and, for example, be used depending on the image-capturing environment, to increase the dynamic range.

In the image-capturing device according to the present disclosure including the image-capturing device A or image-capturing device B according to the present disclosure including the preferred configuration and mode that has been explained above, the wavelength of the light which belongs to the first wavelength band may be, for example, 400 nm or more and less than 650 nm, and the wavelength of the light which belongs to the second wavelength band may be, for example, equal to or more than that (for example, equal to or more than 650 nm) or less than that (for example, less than 400 nm). The first image-capturing element is constituted by at least, for example, the photoelectric conversion element formed in the semiconductor substrate or the semiconductor layer and the color filter formed above the photoelectric conversion element. As described above, the color filter is such that the red color image-capturing element is constituted by the red color filter material, the green color image-capturing element is constituted by the green color filter material, and the blue color image-capturing element is constituted by the blue color filter material. However, it is not limited thereto, and in some cases, the filter may be constituted by color filters transmitting particular wavelengths such as cyan color, magenta color, yellow color, and the like. The second image-capturing element is constituted by the photoelectric conversion element formed on at least, for example, the semiconductor substrate or the semiconductor layer. In the second image-capturing element, a filter may be arranged to cause the light in the first wavelength band from being incident upon the second image-capturing element, or a filter may be arranged to prevent the light other than the light in the second wavelength band from being incident upon the second image-capturing element. The lens system may be a single focus lens, or a so-called zoom lens, the configuration and structure of the lens and the lens system may be determined on the basis of the specification required for the lens system. Examples of image-capturing elements include a CCD (Charge Coupled Devices) image sensor, a CMOS (Complementary Metal Oxide Semiconductor) image sensor, and a CMD (Charge Modulation Device)-type signal amplification-type image sensor. Examples of image-capturing devices include solid state image-capturing devices such as a frontside-illumination type or a backside-illumination type solid state image-capturing device. The image-capturing device according to the present disclosure may constitute, for example, a digital still camera, a camcorder, and a so-called camera-equipped mobile phone. The image-capturing device according to the present disclosure can be used for a camera equipped in, for example, a monitoring camera and a game machine, and used regions, applied regions include an object detection, a monitoring camera, medical equipment, health care, and motion capture.

### [Example 1]

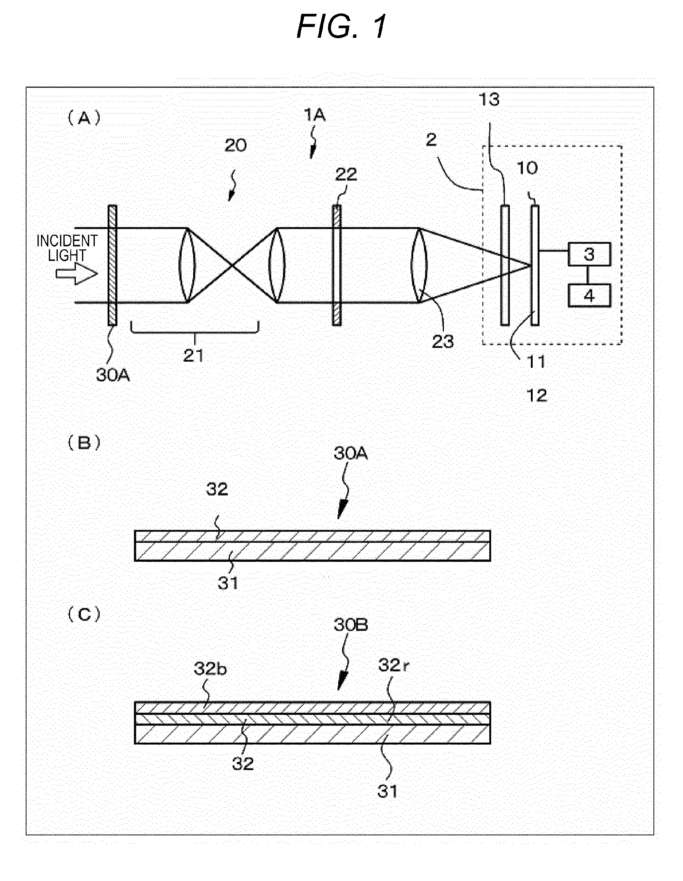

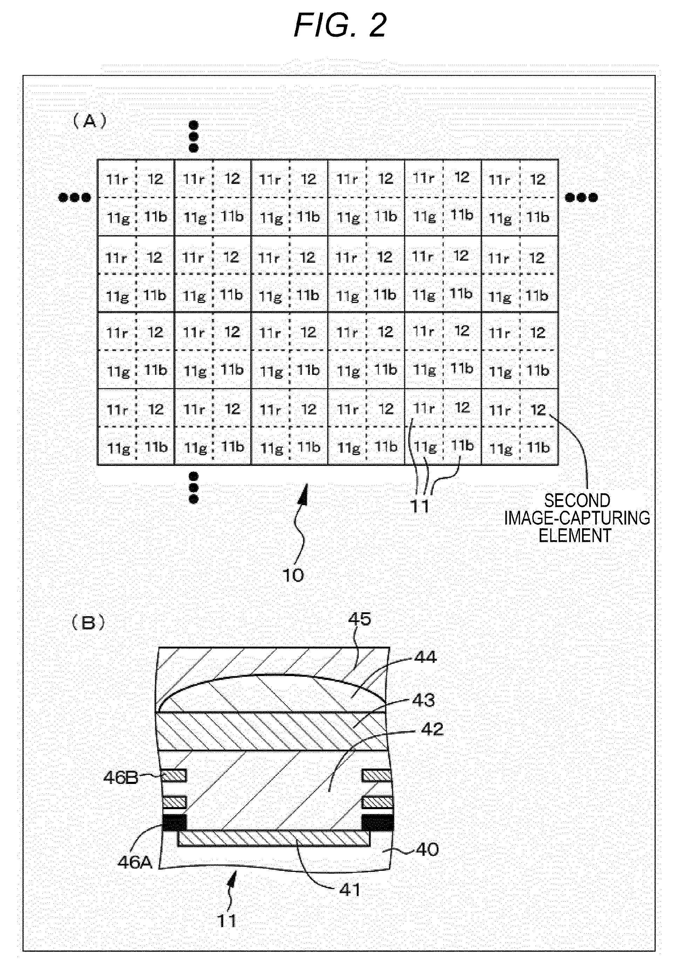

Example 1 relates to an image-capturing device according to the present disclosure, and more specifically, Example 1 relates to the image-capturing device A according to the present disclosure and the filter according to the second aspect of the present disclosure. Fig. 1(A) is a schematic view of an image-capturing device according to Example 1. Fig. 1(B) is a schematic sectional view illustrating a filter according to Example 1 (optical element). Further, Fig. 2(A) schematically illustrates arrangement of image-capturing elements in an image-capturing unit. Fig. 2(B) is a schematic partial sectional view illustrating a first image-capturing element.

The image-capturing device 1A according to Example 1 or image-capturing devices according to Example 2 to Example 9 which will be explained later include a lens system 20 and an image-capturing unit (image-capturing element array unit) 10 upon which light that has passed the lens system 20 is incident. The image-capturing unit (image-capturing element array unit) 10 includes multiple first image-capturing elements 11 configured to receive light in the first wavelength band and multiple second image-capturing elements 12 configured to receive light in the second wavelength band which is different from the first wavelength band. The light condensed by the lens system 20 is converted into an electric signal by the image-capturing unit 10. Further, the image-capturing device (i.e., the lens system 20 or the image-capturing unit 10) includes an optical element with which the light in the first wavelength band of which light quantity which is less than the light quantity of the light in the second wavelength band reaches the image-capturing unit 10.

With the optical element (more specifically, filters 30A, 30B, 30C, 30E, 30F), the light in the first wavelength band of which light quantity is less than the light quantity of the light in the second wavelength band reaches the image-capturing unit 10, and the optical transmittance rate of the light in the first wavelength band is less than the optical transmittance rate of the light in the second wavelength band. In Example 1, the peak wavelength in the first wavelength band is less than the peak wavelength in the second wavelength band. Specifically, the first wavelength band corresponds to the visible light band, and the second wavelength band corresponds to the infrared light band. It should be noted that the image-capturing unit 10 is provided with a UV-cut filter (not shown) configured to cut the ultraviolet light.

In this case, the filters 30A, 30B, 30C according to Example 1, Example 2, or Example 3 are filters configured to pass the light in the first wavelength band and the light in the second wavelength band which is different from the first wavelength band. More specifically, the filters 30A, 30B, 30C according to Example 1, Example 2, or Example 3 are filters configured to pass the light in the first wavelength band which has a wavelength that is shorter than the light in the second wavelength band. In Example 1, the filter 30A is constituted by a material (filter material) in which the optical transmittance rate of the light in the first wavelength band is less than the optical transmittance rate of the light in the second wavelength band, and the filter material layer is a single layer configuration. More specifically, the filter 30A is constituted by a filter base material 31 made of optical glass and transparent resin and a filter material layer 32 made of a filter material formed on the filter base material 31. The filters 30A, 30B according to Example 1 and Example 2 are attached to the front surface portion of the lens system 20. More specifically, the filters 30A, 30B are screwed to the front surface portion of a lens barrel (not shown). It should be noted that the filter 30A may be constituted by a material in which the filter base material 31 also functions as a filter material.

Alternatively, the filter according to Example 1 may be constituted by a dielectric multi-layer film made by alternately laminating multiple layers, i.e., high refractive index material layers and low refractive index material layers. With this configuration, the light in the first wavelength band (visible light) of which light quantity is less than the light quantity of the light in the second wavelength band (infrared light) can reach the image-capturing unit 10.

An IR-cut filter 13 having a well-known configuration, structure for cutting the infrared light having the undesired wavelength is arranged in the image-capturing unit 10, i.e., at the light incidence side of the image-capturing unit 10.

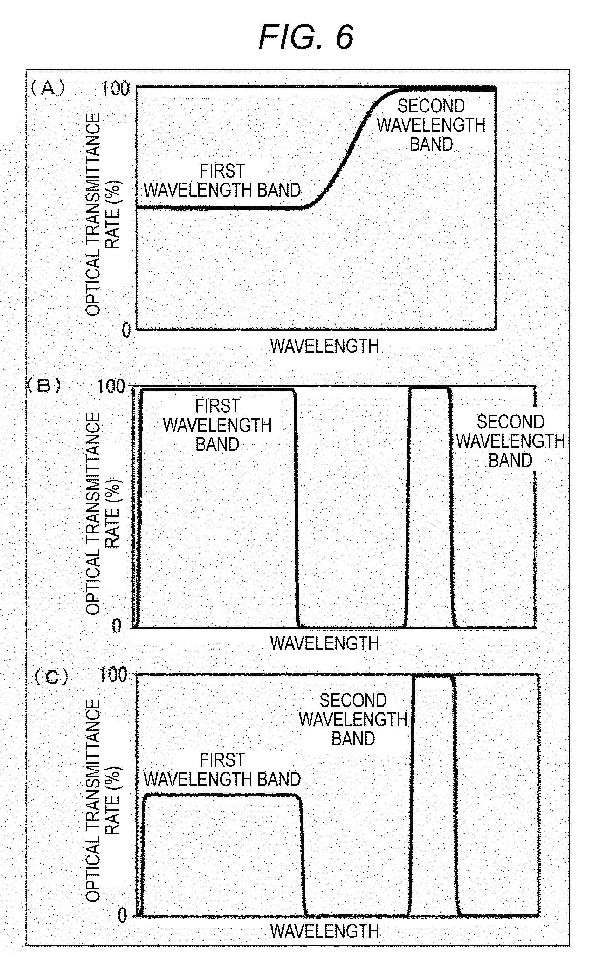

In the filter 30A according to Example 1, an average optical transmittance rate of the wavelength in the first wavelength band (equal to or more than 400 nm, less than 650 nm) is more than 0% and equal to or less than 80%. The average optical transmittance rate of the wavelength in the second wavelength band from 650 nm to 1200 nm is equal to or more than 80%. More specifically, the average optical transmittance rate of the wavelength in the second wavelength band from 650 nm to 1200 nm is almost 100%. Fig. 6(A) schematically illustrates the optical transmittance rate of the filter 30A according to Example 1. Fig. 6(B) schematically illustrates the optical transmittance rate of the optical transmittance rate of the IR-cut filter 13. Fig. 6(C) schematically illustrates the optical transmittance rate in a combination of the filter 30A according to Example 1 and the IR-cut filter 13. In the example as illustrated in Fig. 6(C), although depending on the purpose of the image-capturing device, for example, this cuts the near-infrared light having an undesired wavelength in a range of 650 nm to 850 nm. Alternatively, although depending on the purpose of the image-capturing device, for example, the near infrared light having an undesired wavelength in a range of 650 nm to 800 nm is cut, and the near infrared light having an undesired wavelength in a range of 650 nm to 900 nm is cut. Further, for example, when the near infrared light having a undesired wavelength in a range of 650 nm to 800 nm is to be cut, it is preferable to cut the near infrared light having an undesired wavelength in a range of, for example, 900 nm to 1200 nm. However, the wavelength range of the infrared light which is to be cut is not limited to the wavelength ranges described above.

In the lens system 20, an image-capturing lens 21, a diaphragm unit 22, and an image-condensing lens 23 are accommodated in the lens barrel, and they function as a zoom lens. The image-capturing lens 21 is a lens for condensing the incident light which is incident from a subject. The image-capturing lens 21 includes a focus lens for adjusting the focal point a zoom lens for enlarging the subject, and the like, and in general, it is achieved by a combination of multiple lenses in order to correct chromatic aberration and the like. The diaphragm unit 22 has a function of narrowing down in order to adjust the amount of light condensed, and in general, it is constituted by a combination of multiple diaphragm blades in a plate shape. The light from a point of the subject becomes parallel light at least at the position of the diaphragm unit 22. The image-condensing lens 23 condenses the light onto the image-capturing unit 10. The image-capturing unit 10 is arranged inside of the camera main body unit 2. The image-capturing device constitutes, for example, a digital still camera, a video camera, and a camcorder. The camera main body unit 2 includes not only the image-capturing unit 10 but also, for example, image processing means 3 and image storage unit 4. Then, image data are formed on the basis of an electric signal converted by the image-capturing unit 10. The image processing means 3 converts the electric signal, which is output from the image-capturing unit 10, into the image data, and records the image data to the image storage unit 4. It should be noted that, for example, well-known demosaic processing may be performed on the electric signal that is obtained from the image-capturing element.

The image-capturing elements 11, 12 may be CCD image sensors and CMOS image sensors, and in the example as shown in the figure, they are frontside-illumination type. The first image-capturing element 11 is constituted by an image-capturing element unit which is made up with a red color image-capturing element 11r, a green color image-capturing element 11g, and a blue color image-capturing element 11b, and the second image-capturing element 12 is constituted by an infrared light image-capturing element which detects the infrared light. One pixel is constituted by one image-capturing element unit and one infrared light image-capturing element. The mode of arrangement of the image-capturing element is Bayer arrangement, and in the image-capturing unit 10, one pixel (the infrared light/ultraviolet light-sensitive image-capturing element unit) constituting by the four image-capturing elements are arranged in a two-dimensional matrix form.

As shown in Fig. 2(B) illustrating the schematic partial sectional view, the first image-capturing element 11 is laminated such that, for example, a photoelectric conversion element 41 is provided on a silicon semiconductor substrate 40, and a first planarization film 42, a color filter 43, an on-chip lens 44, and a second planarization film 45 are laminated thereon. The second image-capturing element 12 has the same configuration, structure as the first image-capturing element 11 except that the color filter 43 is provided. However, this is not limited thereto. Alternatively, the second image-capturing element 12 may be provided with a filter for cutting the light in the first wavelength band. It should be noted that reference numeral 46A denotes a light-shielding layer, and reference numeral 46B denotes a wiring layer.

As described above, in the image-capturing device 1A according to Example 1, the lens system 20 causes the light in the first wavelength band of which light quantity is less than the light quantity of the light in the second wavelength band to reach the image-capturing unit 10, and moreover, the optical element (filter 30A) is provided in which the optical transmittance rate of the light in the first wavelength band is less than the optical transmittance rate of the light in the second wavelength band. In the filter 30A according to Example 1, the optical transmittance rate of the light in the first wavelength band is lower than the optical transmittance rate of the light in the second wavelength band. More specifically, in Example 1, the filter 30A is constituted by a material in which the optical transmittance rate of the light in the first wavelength band is lower than the optical transmittance rate of the light in the second wavelength band. Therefore, as the entire filter 30A, more quantity of light in the second wavelength band reaches the image-capturing unit 10, and less quantity of light in the first wavelength band reaches the image-capturing unit 10. As a result, the image-capturing unit 10 can detect the light in the first wavelength band and the light in the second wavelength band with the same level of sensitivity.

### [Example 2]

Example 2 is a modification of Example 1. In Example 1, the filter material layer 32 is constituted by a single layer. On the other hand, in Example 2, as shown in Fig. 1C illustrating the schematic sectional view, the filter 30B is made by laminating the red color transmission layer 32r that is configured to transmit the red color and the blue color transmission layer 32b that is configured to transmit the blue color. More specifically, the red color transmission layer 32r is constituted by a red color filter material which is the same as a color filter that transmitting red color, which is provided above the photoelectric conversion element of the image-capturing element. The blue color transmission layer 32b is constituted by a blue color filter material which is the same as a color filter that transmitting blue color, which is provided above the photoelectric conversion element of the image-capturing element. The thicknesses of the red color transmission layer 32r and the blue color transmission layer 32b may be determined on the basis of the relationship between the thickness and the optical transmittance rate of the red color transmission layer, the relationship between the thickness and the optical transmittance rate of the blue color transmission layer, and the target optical transmittance rate.

Except the above features, the configuration and the structure of the filter and the image-capturing device according to Example 2 are the same as the configuration and the structure of the filter and the image-capturing device which have been explained in Example 1, and therefore, detailed description about the configuration and the structure of the filter and the image-capturing device according to Example 2 will be omitted. The filter of Example 2 may be configured to be made by laminating the red color transmission layer that is configured to transmit the red color, the green color transmission layer that is configured to transmit the green color, and the blue color transmission layer that is configured to transmit the blue color. It should be noted that the green color transmission layer may be constituted by a green color filter material which is the same as a color filter that transmitting green color, which is provided above the photoelectric conversion element of the image-capturing element. The thicknesses of the red color transmission layer, the green color transmission layer, and the blue color transmission layer may be determined on the basis of the relationship between the thickness and the optical transmittance rate of the red color transmission layer, the thickness and the optical transmittance rate of the green color transmission layer, the thickness and the optical transmittance rate of the blue color transmission layer, and the target optical transmittance rate.

### [Example 3]

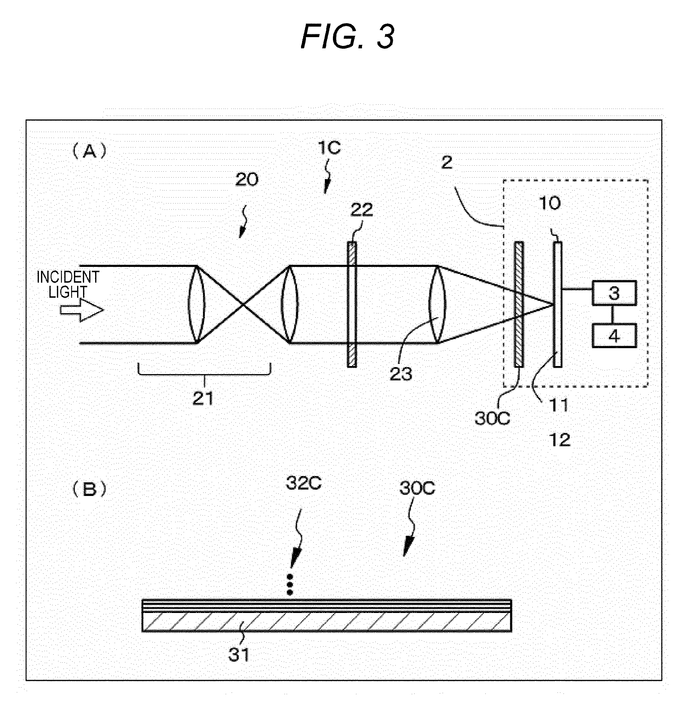

Example 3 is also a modification of Example 1, but Example 3 relates to the image-capturing device A-2 according to the present disclosure and the filter according to the aspect 2-2 of the present disclosure. The conceptual diagram of the image-capturing device 1C according to Example 3 and the schematic sectional view of the filter according to Example 3 are show in Fig. 3(A) and Fig. 3(B), respectively. In Example 3, a filter 30C is constituted by a dielectric multi-layer film 32C. In other words, the filter 30C is constituted by a dielectric multi-layer film 32C made by alternately laminating multiple layers, i.e., high refractive index material layers and low refractive index material layers. With this configuration, the light in the first wavelength band (visible light) of which light quantity is less than the light quantity of the light in the second wavelength band (infrared light) can reach the image-capturing unit 10. Moreover, in Example 3, the filter 30C has optical transmittance rate characteristics as shown in Fig. 6(C). In other words, the filter 30C of Example 3 is constituted by a dielectric multi-layer film for cutting the infrared light having an undesired wavelength, and it has the function of the ND filter and the function of the IR-cut filter. Further, the filter 30C is arranged inside of the image-capturing unit 10. More specifically, the filter 30C is at the light incidence side of the image-capturing unit 10. This configuration makes it unnecessary to have a conventional IR-cut filter 13 for cutting the infrared light having an undesired wavelength. When the filter is constituted by the dielectric multi-layer film, there may be dependency upon the incidence angle of the light onto the filter, and therefore, it is preferable to be arranged inside of the image-capturing unit 10 in this manner. Except the above feature, the configuration and the structure of the filter and the image-capturing device 1C of Example 3 can be the same as the configuration and the structure of the filter and the image-capturing device 1A explained in Example 1, and therefore, detailed explanation thereabout is omitted. It should be noted that, in some cases, the filter 30C may be arranged in the lens system 20.

### [Example 4]

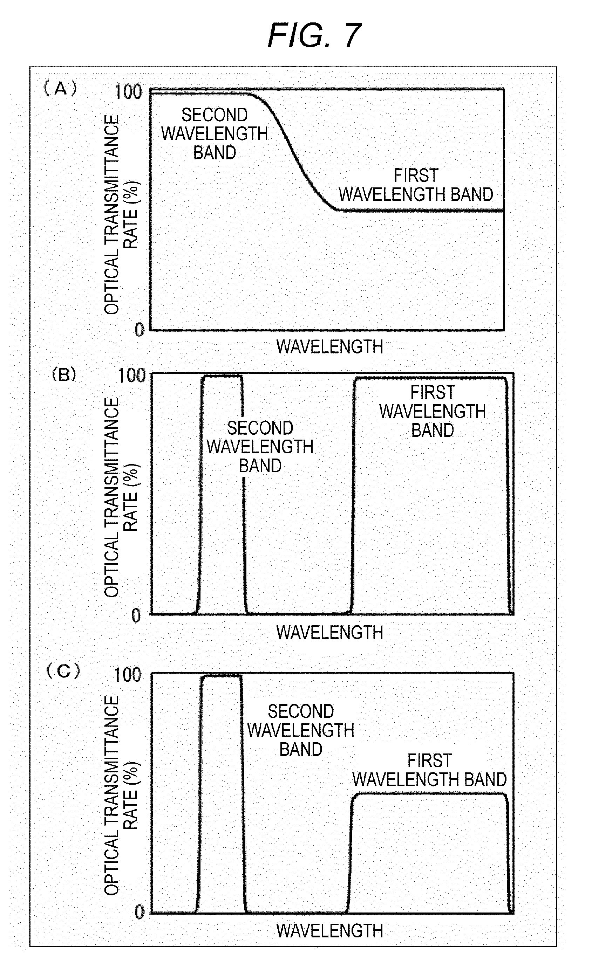

Example 4 is also a modification of Example 1 to Example 3. However, in Example 4, the peak wavelength in the first wavelength band is longer than the peak wavelength in the second wavelength band. More specifically, the first wavelength band corresponds to the visible light band, and the second wavelength band corresponds to the ultraviolet light band. In the image-capturing unit 10, an IR-cut filter (not shown) for cutting the infrared light is provided. The optical element (filter) of Example 1 is more specifically a filter for passing the light in the second wavelength band having a wavelength that is shorter than the light in the first wavelength band, and is constituted by a dielectric multi-layer film made by alternately laminating multiple layers, i.e., high refractive index material layers and low refractive index material layers. In Example 1, the average optical transmittance rate in a wavelength in the first wavelength band (equal to or more than 400 nm, less than 650 nm) is more than 0%, and equal to or less than 80%, and more specifically, the average optical transmittance rate in a wavelength in the first wavelength band (equal to or more than 400 nm, less than 650 nm) is, for example, about 50% (alternatively, about 25%, and alternatively, about 12.5%). The average optical transmittance rate in a wavelength in the second wavelength band (less than 400 nm) is equal to or more than 80%, and more specifically, the average optical transmittance rate in a wavelength in the second wavelength band (less than 400 nm) is about 100%. The configuration and the structure of the image-capturing device according to Example 4 may be the same as the configuration and the structure of the image-capturing device according to Example 1 and Example 2 except that the image-capturing unit 10 is provided with a UV-cut filter for cutting the ultraviolet light instead of the IR-cut filter, or may be the same configuration and the structure as the image-capturing device according to Example 3, and therefore, detailed description thereabout is omitted. Figs. 7(A), 7(B), and 7(C) schematically illustrate the optical transmittance rate of the filter according to Example 4, the optical transmittance rate of the UV-cut filter, and the optical transmittance rate in a combination of the filter according to Example 4 and the UV-cut filter.

### [Example 5]

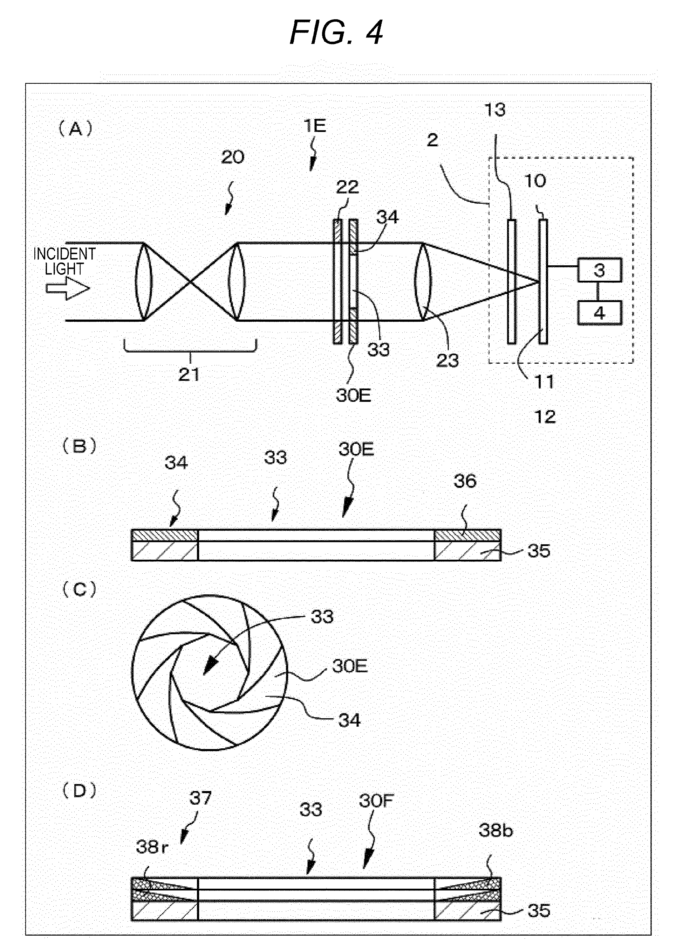

Example 1 relates to an image-capturing device according to the present disclosure. More specifically, Example 1 relates to an image-capturing device B according to the present disclosure and a filter according to the first aspect of the present disclosure. Fig. 4(A) illustrates a schematic view of an image-capturing device 1E according to Example 5. Fig. 4(B) illustrates a schematic sectional view of a filter 30E of Example 5. Fig. 4(C) illustrates a schematic front view of a filter 30E of Example 5.

Like Example 1, Example 5 is configured such that the peak wavelength in the first wavelength band is shorter than the peak wavelength in the second wavelength band. Specifically, the first wavelength band corresponds to the visible light band, and the second wavelength band corresponds to the infrared light band. Like Example 1, it should be noted that the image-capturing unit 10 is provided with a UV-cut filter (not shown) for cutting the ultraviolet light. The optical element according to Example 5 (filter 30E) or the optical element according to Example 5 (filter 30F) are constituted by the first region 33 having a circular or regular polygonal external shape of (more specifically, a regular octagonal shape) and the second region 34 in a ring shape that encircles the first region 33, and the first region 33 passes the light in the first wavelength band and the light in the second wavelength band that is different from the first wavelength band (more specifically, the first region 33 passes the light in the second wavelength band having a wavelength longer than the light in the first wavelength band), and in the second region 34, the optical transmittance rate of the light in the first wavelength band is lower than the optical transmittance rate of the light in the second wavelength band.

In this case, the size of the first region 33 is variable in the filters 30E, 30F. The filters 30E, 30F have, for example, the same structure as the diaphragm blade. The filter base material 35 constituting the filters 30E, 30F is made of optical glass and transparent resin. The filter material layer 36 made of a well-known filter material available in the market for cutting the infrared light is formed on the filter base material 35. The filter base material 35 and the filter material layer 36 constitute the second region 34, and the first region 33 is constituted by the aperture portion in the filters 30E, 30F having the same structure as the diaphragm blade. In the schematic sectional view illustrating the filter 30E of Fig. 4(B), overlapping of the diaphragm blade structure is not shown. In Example 5, the layer thickness of the filter material layer 36 is constant. The mechanism for changing the size of the first region 33 may be the same as the mechanism for controlling the state of the diaphragm of the diaphragm unit. The filters 30E, 30F are arranged adjacent to the diaphragm unit 22 provided in the lens system 20. Alternatively, the filters 30E, 30F are arranged in a portion of the lens system 20 in the parallel light state when the light incident upon the lens system 20 is once made into the parallel light, and ultimately, the light is condensed on the image-capturing elements 11, 12 (image-condensed). It should be noted that the filter 30E may be constituted by a material in which the filter base material 35 also functions as a filter material. The filters 30E, 30F may be constituted by the dielectric multi-layer film explained in Example 1.

As described above, in the image-capturing device 1E according to Example 5, the lens system 20 causes the light in the first wavelength band of which light quantity is less than the light in the second wavelength band to reach the image-capturing unit 10, and in addition, the filter 30E is provided in which the optical transmittance rate of the light in the second wavelength band is lower than the optical transmittance rate of the light in the first wavelength band. In the filter 30E in Example 5, in the second region 34, the optical transmittance rate of the light in the first wavelength band is lower than the optical transmittance rate of the light in the second wavelength band. Therefore, in the entire filter 30E, more light in the second wavelength band reaches the image-capturing unit 10, and less light in the first wavelength band reaches the image-capturing unit 10. As a result, the light in the first wavelength band and the light in the second wavelength band can be detected with the same level of sensitivity.

It should be noted that the size of the first region 33 is configured to be smaller than the size of the aperture portion of the diaphragm unit 22, so that the visible light that is incident upon the image-capturing unit 10 is substantially narrowed by the first region 33. The infrared light that passes through the aperture portion of the diaphragm unit 22 passes through the first region 33 and the second region 34 and reaches the image-capturing unit 10. As shown in the figure, the positional relationship of the diaphragm unit 22 and the filter 30E may be such that the filter 30E may be located at the image-capturing unit side, and on the contrary, the diaphragm unit 22 is located at the image-capturing unit side.

### [Example 6]

Example 6 is a modification of Example 5. As shown in Fig. 4(D) illustrating the schematic sectional view, in the filter 30F according to Example 6, the optical transmittance rate of the light in the first wavelength band gradually decreases from the portion of the second region 37 at the border of the first region 33 and the second region 37 to the external periphery of the second region 37. Alternatively, the filter 30F is made of the apodization filter.

Specifically, the second region 37 of the filter 30F according to Example 6 is made by laminating the red color transmission layer 38r that is configured to transmit the red color and the blue color transmission layer 38b that is configured to transmit the blue color, and the thickness of the red color transmission layer 38r and the thickness of the blue color transmission layer 38b increase from the portion of the second region 37 at the border between the first region 33 and the second region 37 to the external periphery of the second region 37. The red color transmission layer 38r and the blue color transmission layer 38b are constituted by the color filter material explained in Example 2.

More specifically, in the red color transmission layer 38r and the blue color transmission layer 38b, the thickness at the portion of the second region 37 at the border between the first region 33 and the second region 37 is 0 µm, and the thickness at the external peripheral portion of the second region 37 is determined on the basis of the relationship between the thickness and the optical transmittance rate of the red color transmission layer, the thickness and the optical transmittance rate of the blue color transmission layer, and the target optical transmittance rate. The thickness increases in accordance with the Gaussian function.

Except the above features, the configuration and the structure of the image-capturing device and the filter according to Example 6 can be the same as the configuration and the structure of the image-capturing device and the filter explained in Example 5, and therefore, detailed description thereabout is omitted. It should be noted that the red color transmission layer 38r and the blue color transmission layer 38b can be formed on the basis of, for example, film thickness inclination (wedge) deposition method, or manufacturing method of a wedge shape film disclosed in JP 2003-155556 A. The second region of the filter is made by laminating the red color transmission layer that is configured to transmit the red color, the green color transmission layer that is configured to transmit the green color, and the blue color transmission layer that is configured to transmit the blue color, and may be configured such that the thickness of the red color transmission layer, the thickness of the green color transmission layer, and the thickness of the blue color transmission layer 38b are configured to become thicker from the portion of the second region at the border between the first region and the second region to the external periphery of the second region. The filters 30E, 30F may be constituted by the dielectric multi-layer film explained in Example 1.

### [Example 7]

Example 7 is also a modification of Example 5 or Example 6. However, like Example 4, Example 7 is configured such that the peak wavelength in the first wavelength band is longer than the peak wavelength in the second wavelength band. More specifically, the first wavelength band corresponds to the visible light band, and the second wavelength band corresponds to the ultraviolet light band. The image-capturing unit 10 is provided with a UV-cut filter (not shown) for cutting the ultraviolet light. More specifically, the optical element (filter) according to Example 7 is a filter for passing the light in the second wavelength band having a wavelength shorter than the light in the first wavelength band. In Example 7, the average optical transmittance rate of the wavelength in the first wavelength band (equal to or more than 400 nm, less than 650 nm) is more than 0%, and equal to or less than 80%. More specifically, the average optical transmittance rate of the wavelength in the first wavelength band (equal to or more than 400 nm, less than 650 nm) is, for example, about 50% (or about 25%, or about 12.5%), and the average optical transmittance rate of the wavelength in the second wavelength band (less than 400 nm) is equal to or more than 80%, and more specifically, about 100%. The configuration and the structure of the image-capturing device according to Example 7 can be the same configuration and the structure as the image-capturing device according to Example 5 or Example 6 except that the image-capturing unit 10 is provided with a UV-cut filter for cutting the ultraviolet light instead of being provided with the IR-cut filter, and detailed description thereabout is omitted.

### [Example 8]

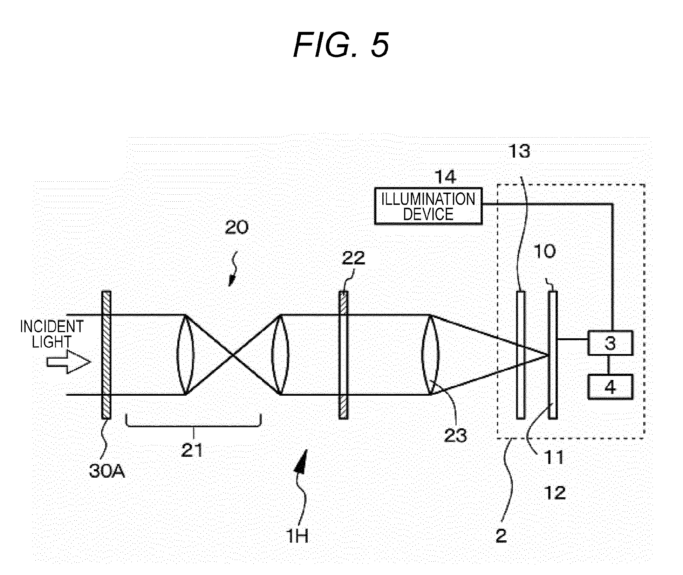

Example 8 is a modification of Example 1 to Example 7. As shown in Fig. 5 illustrating a schematic view of the image-capturing device according to Example 8, the image-capturing device 1H of Example 8 further includes an illumination device 14 configured to emit the light in the second wavelength band. The illumination device 14 is some kind of strobe light emission device. In this case, in Example 8, the light in the second wavelength band that is emitted by the illumination device 14 includes multiple peak wavelengths (more specifically, the light in the second wavelength band that is emitted by the illumination device 14 includes two peak wavelengths in Example 8). In this case, for example, the peak wavelength may be 850 nm and 940 nm. The light source constituting the illumination device 14 is made up with N-types of light sources (more specifically, the light source constituting the illumination device 14 is made up with two types of LEDs including an LED for emitting the infrared light of which peak wavelength is 850 nm and an LED for emitting the infrared light of which peak wavelength is 940 nm).

In Example 8, the illumination device 14 is caused to emit light N times (more specifically, the illumination device 14 is caused to emit light twice in Example 8), and the image-capturing is performed N times (more specifically, the image-capturing is performed twice) in the light in the second wavelength band of different peak wavelengths, so that the second image-capturing element 12 obtains N types of image data (more specifically, the second image-capturing element 12 obtains two types of image data). Alternatively, although depending on the optical transmittance rate characteristics of the filter, the entire illumination device 14 is caused to emit light once, and the image-capturing is performed once in the light in the second wavelength band of different peak wavelengths, so that the second image-capturing element 12 can obtain N types of image data. Then, by analyzing these N types of image data, various kinds of information can be obtained. It should be noted that the optical transmittance rate of the light by the optical element in the second wavelength band may be optimized in accordance with the light source. More specifically, in accordance with N types of light sources, the optical transmittance rate of the light in the second wavelength band in the optical element may be optimized, and the ratio of the optical transmittance rate for the lights from the N types of light sources may be optimized, and the optical spectrum may be optimized.

Except the above features, the image-capturing device according to Example 8 can be of the same configuration and the structure as the image-capturing device explained in Example 1 to Example 2 and Example 5 to Example 6, and therefore, detailed description thereabout is omitted. It should be noted that, when the light in the second wavelength band that is emitted by the illumination device 14 is the ultraviolet light, the image-capturing the image-capturing device according to Example 8 can be of the same configuration and the structure as the image-capturing device explained in Example 4 and Example 7.

### [Example 9]

Example 9 is a modification of Example 1 to Example 8. In the image-capturing device according to the Example 9, the image processing means 3 is provided with an image processing unit. This image processing unit includes a first gain adjustment unit configured to adjust the output given by the first image-capturing element 11 and a second gain adjustment unit configured to adjust the output given by the second image-capturing element 12. Where the adjustment coefficient by the first gain adjustment unit for the output given by the first image-capturing element 11 is denoted as Gn₁, and the adjustment coefficient by the second gain adjustment unit for the output given by the second image-capturing element 12 is denoted as Gn₂, Gn₁/Gn₂ ≥ 1 is satisfied. The value of (Gn₁/Gn₂) may be, for example, specifically, 2, 4, 8, and the like. Accordingly, when the image-capturing environment changes, the light quantity of the light in the first wavelength band (visible light) reaching the first image-capturing element 11 decreases, and the difference from the light quantity of the light in the second wavelength band (infrared light or ultraviolet light) reaching the second image-capturing element 12 greatly changes. Even in such case, the difference in the brightness between the image obtained by the first image-capturing element 11 and the image obtained by the second image-capturing element 12 can be reduced.

Except the above features, the image-capturing device according to Example 9 can be of the same configuration and the structure as the image-capturing device explained in Example 1 to Example 8, and therefore, detailed description thereabout is omitted. It should be noted that the light quantity of the light in the first wavelength band reaching the first image-capturing element 11 decreases, and in accordance with the difference from the light quantity of the light in the second wavelength band reaching the second image-capturing element 12, the adjustment coefficients Gn₁, Gn₂ may be changed automatically or manually.

The present disclosure has been hereinabove explained on the basis of preferred Examples. However, the present disclosure is not limited to these Examples. The configuration and the structure of the image-capturing device, the image-capturing element, the optical element, and the filter which have been explained in Examples are merely shown as examples, and can be changed as necessary. The image-capturing element may be the frontside-illumination type as shown in the drawing, or may be the backside-illumination type which is not shown. In the image-capturing unit, for example, one row of infrared light/ultraviolet light-sensitive image-capturing element unit may be arranged, and a visible light-sensitive image-capturing element unit constituted by one red color image-capturing element, two green color image-capturing elements, and one blue color image-capturing element may be arranged in (2ⁿ-1) rows adjacent to this row (where n is, for example, a positive integer equal to or more than one and equal to or less than five).

In Example 5 to Example 7, the filters 30E, 30F may be arranged detachably to/from the lens system 20. More specifically, for example, in the lens system 20, a member arranged with not only the filter 30 but also an aperture may be attached to a rotation shaft in such a manner that it can rotate about the rotation shaft parallel to the optical axis of the lens system 20, and such member is rotated about the rotation shaft, whereby the optical line passing through the lens system 20 passes through the aperture, or, passes through the filter 30. Alternatively, in the lens system 20, a member arranged with not only the filter 30 but also the aperture portion may be attached to the lens system 20 in such a manner that it can slide in a direction perpendicular to the optical system of the lens system 20, for example, and when such member is slid, the optical line passing through the lens system 20 passes through the aperture portion, or, passes through the filter 30.

In order to obtain black and white (gray) image with an image-capturing device, one pixel may be configured to be constituted by one image-capturing element unit and one second image-capturing element. In Examples, the photoelectric conversion element is provided on the silicon semiconductor substrate, but the used substrate is not limited to the silicon semiconductor substrate. For example, it may be possible to use a Si-Ge substrate, a Ge substrate, chalcopyrite substrate made of, e.g., Cu, In, Ga, Al, Se, S (for example, Cu-In-Ga-Se substrate), a GaAs substrate, and the like. In this case, the reception optical sensitive wavelength band of the photoelectric conversion element can be enlarged or changed.

Examples of usage fields and application fields of the image-capturing device according to the present disclosure include a monitoring camera, medical equipment, health care, and motion capture. More specifically, when the image-capturing device according to the present disclosure is applied to a monitoring camera, the following daytime/night monitoring camera can be shown as an example: the monitoring camera captures images in an ordinary manner in daytime, and at night, there is little visible light component which is the first wavelength band, and therefore, an illumination device made of an LED light source including the second wavelength band is used to capture images. In this case, the infrared light is assumed as the second wavelength band. When the image-capturing device according to the present disclosure is applied to medical equipment and healthcare, ordinary image-capturing process is done with visible light, and at the same time, an illumination device made of an LED light source including the second wavelength band is used to obtain reflection/absorption characteristics in the second wavelength band of image-capturing target, so that, for example, oxygen saturation concentration in the blood can be measured, and the image-capturing device according to the present disclosure can be used for diagnosis of the health state of a patient. When the image-capturing device according to the present disclosure is applied to motion capture, ordinary image-capturing process is done with visible light, and the near infrared light is used as the second wavelength band, and distance information and motion information in normal image-capturing state are obtained, and by recombining the images obtained with the visible light which is the first wavelength region, the ordinary images and the distance/motion information can be obtained at a time.

Together with or independently from the use of the filter according to the present disclosure which has been explained above, a first aperture region may be formed at the light incidence side of the first image-capturing element, and a second aperture region may be formed at the light incidence side of the second image-capturing element, and the first aperture region may be configured to be smaller than the second aperture region. In such configuration, the light quantity received by the second image-capturing element may be less than the light quantity received by the first image-capturing element. The aperture region can be obtained by forming an aperture region having a desired size, i.e., a desired aperture size, in the light-shielding layer formed at the light incidence side of the photoelectric conversion element. Examples of planar shapes of the aperture region include a circular, or a regular polygonal shape (for example, a regular pentagonal shape, a regular hexagonal shape, a regular heptagonal shape, and a regular octagonal shape). It should be noted that the regular polygonal shape includes quasi-regular polygonal shapes (a regular polygonal shape each side of which is constituted by a curved line, a regular polygonal shape of which vertex is round).

It should be noted that the present disclosure may be configured as follows.
[1] «image-capturing device»
   An image-capturing device including a lens system and an image-capturing unit upon which light having passed through the lens system is incident,
   wherein the image-capturing unit includes a plurality of first image-capturing elements configured to receive light in a first wavelength band and a plurality of second image-capturing elements configured to receive light in a second wavelength band which is different from the first wavelength band, and
   an optical element is provided so that the light in the first wavelength band of which light quantity is less than the light quantity of the light in the second wavelength band reaches the image-capturing unit.
[2]The image-capturing device according to the item [1], wherein a peak wavelength in the first wavelength band is shorter than a peak wavelength in the second wavelength band.
[3]The image-capturing device according to the item [1], wherein a peak wavelength in the first wavelength band is longer than a peak wavelength in the second wavelength band.
[4]The image-capturing device according to the item [2] or [3],
   wherein an average optical transmittance rate of an optical element where the wavelength in the first wavelength band is equal to or more than 400 nm and less than 650 nm is more than 0% and equal to or less than 80%, and
   an average optical transmittance rate of the optical element in the second wavelength band is 80% or more.
[5]The image-capturing device according to any one of the items [2] to [4], wherein
   an optical element is made of a filter, and
   in the filter, an optical transmittance rate of the light in the first wavelength band is lower than an optical transmittance rate of the light in the second wavelength band.
[6]The image-capturing device according to the item [5], wherein the filter is made of a material in which the optical transmittance rate of the light in the first wavelength band is lower than the optical transmittance rate of the light in the second wavelength band.
[7]The image-capturing device according to the item [6], wherein the optical element is made of laminating a red color transmission layer that is configured to transmit red color and a blue color transmission layer that is configured to transmit blue color.
[8]The image-capturing device according to the item [5], wherein the filter is made of a dielectric multi-layer film.
[9]The image-capturing device according to any one of the items [2] to [8], wherein the optical element is attached to the lens system.
[10]The image-capturing device according to the item [8], wherein the optical element is arranged in the image-capturing unit.
[11]The image-capturing device according to any one of the items [2] to [4],
   wherein an optical element is made of a filter, and
   the filter includes a first region having an external shape in a circular or regular polygonal shape and a second region in a ring shape encircling the first region, and
   the first region passes the lights in the first wavelength band and the second wavelength band, and
   in the second region, an optical transmittance rate of the light in the first wavelength band is lower than an optical transmittance rate of the light in the second wavelength band.
[12]The image-capturing device according to the item [11], wherein from a portion of the second region at a border between the first region and the second region to an external periphery of the second region, the optical transmittance rate of the light in the first wavelength band gradually decreases.
[13]The image-capturing device according to the item [11], wherein the filter is made of an apodization filter.
[14]The image-capturing device according to any one of the items [11] to [13], wherein the size of the first region is variable.
[15]The image-capturing device according to any one of the items [11] to [14], wherein the optical element is arranged adjacent to a diaphragm unit provided in the lens system.
[16]The image-capturing device according to any one of the items [11] to [15], wherein the optical element is arranged detachably to/from the lens system.
[17]The image-capturing device according to any one of the items [1] to [16], wherein first image-capturing element is constituted by an image-capturing element unit including a red color image-capturing element, a green color image-capturing element, and a blue color image-capturing element.
[18]The image-capturing device according to the item [17], wherein one pixel is constituted by one image-capturing element unit and one second image-capturing element.
[19]The image-capturing device according to any one of the items [1] to [16], wherein one pixel is constituted by one image-capturing element unit and one second image-capturing element.
[20]The image-capturing device according to any one of the items [1] to [19],
   wherein a first aperture region is formed at a light incidence side of the first image-capturing element,
   a second aperture region is formed at a light incidence side of the second image-capturing element, and
   the first aperture region is smaller than the second aperture region.
[21]The image-capturing device according to any one of the items [1] to [20] further including an illumination device configured to emit the light in the second wavelength band.
[22]The image-capturing device according to the item [21], wherein the light in the second wavelength band emitted by the illumination device includes multiple peak wavelengths.
[23] <<filter: the first aspect>>
   A filter including a first region having an external shape in a circular or regular polygonal shape and a second region in a ring shape encircling the first region,
   wherein the first region passes light in a first wavelength band and light in a second wavelength band which is different from the first wavelength band, and
   in the second region, an optical transmittance rate of the light in the first wavelength band is lower than the optical transmittance rate of the light in the second wavelength band.
[24]The filter according to the item [23], wherein from a portion of the second region at a border between the first region and the second region to an external periphery of the second region, the optical transmittance rate of the light in the first wavelength band gradually decreases.
[25]The filter according to the item [23] or [24], which is made of an apodization filter.
[26]The filter according to any one of the items [23] to [25], wherein the size of the first region is variable.
[27] <<filter: the second aspect>>
   A filter for passing light in a first wavelength band and light in a second wavelength band which is different from the first wavelength band,
   wherein an optical transmittance rate of the light in the first wavelength band is lower than an optical transmittance rate of the light in the second wavelength band.
[28]The filter according to the item [27], wherein
   an average optical transmittance rate where the wavelength in the first wavelength band is equal to or more than 400 nm and less than 650 nm is more than 0% and equal to or less than 80%, and
   an average optical transmittance rate in the second wavelength band is 80% or more.
[29]The filter according to the item [27] or [28] which is made of a material in which the optical transmittance rate of the light in the first wavelength band is lower than the optical transmittance rate of the light in the second wavelength band.
[30]The filter according to the item [29] which is made by laminating a red color transmission layer that is configured to transmit red color and a blue color transmission layer that is configured to transmit blue color.
[31] The filter according to the item [27] or [28] which is made of a dielectric multi-layer film.

### REFERENCE SIGNS LIST

- 1A, 1D, 1E, 1H: Image-capturing device
- 2: Camera main body unit
- 3: Image processing means
- 4: Image storage unit
- 10: Image-capturing unit (image-capturing element array unit)
- 11: First image-capturing element
- 11r: Red color image-capturing element
- 11g: Green color image-capturing element
- 11b: Blue color image-capturing element
- 12: Second image-capturing element
- 13: IR-cut filter
- 14: Illumination device
- 20: Lens system
- 21: Image-capturing lens
- 22: Diaphragm unit
- 23: Image-condensing lens
- 30A, 30B, 30C, 30E, 30F: Filter (optical element)
- 31: Filter base material
- 32: Filter material layer
- 32r, 38r: Red color transmission layer
- 32b, 38b: Blue color transmission layer
- 32C: Dielectric multi-layer film
- 33: First region
- 34, 37: Second region
- 35: Filter base material
- 36: Filter material layer
- 40: Silicon semiconductor substrate
- 41: Photoelectric conversion element
- 42: First planarization film
- 43: Color filter
- 44: On-chip lens
- 45: Second planarization film
- 46A, 46B: Wiring layer

## Claims

1. An image-capturing device comprising a lens system and an image-capturing unit upon which light having passed through the lens system is incident,
wherein the image-capturing unit includes a plurality of first image-capturing elements configured to receive light in a first wavelength band and a plurality of second image-capturing elements configured to receive light in a second wavelength band which is different from the first wavelength band, and
an optical element is provided so that the light in the first wavelength band of which light quantity is less than the light quantity of the light in the second wavelength band reaches the image-capturing unit.

2. The image-capturing device according to claim 1, wherein the peak wavelength in a first wavelength band is shorter than a peak wavelength in the second wavelength band.

3. The image-capturing device according to claim 1, wherein a peak wavelength in the first wavelength band is longer than a peak wavelength in the second wavelength band.

4. The image-capturing device according to claim 2 or claim 3,
wherein an optical element is made of a filter, and
in the filter, an optical transmittance rate of the light in the first wavelength band is lower than an optical transmittance rate of the light in the second wavelength band.

5. The image-capturing device according to claim 2 or 3,
wherein an optical element is made of a filter, and
the filter includes a first region having an external shape in a circular or regular polygonal shape and a second region in a ring shape encircling the first region, and
the first region passes the lights in the first wavelength band and the second wavelength band, and
in the second region, an optical transmittance rate of the light in the first wavelength band is lower than an optical transmittance rate of the light in the second wavelength band.

6. The image-capturing device according to claim 5, wherein from a portion of the second region at a border between the first region and the second region to an external periphery of the second region, the optical transmittance rate of the light in the first wavelength band gradually decreases.

7. The image-capturing device according to claim 5, wherein the filter is made of an apodization filter.

8. The image-capturing device according to claim 5, wherein the size of the first region is variable.

9. The image-capturing device according to claim 1, wherein the first image-capturing element is constituted by an image-capturing element unit including a red color image-capturing element, a green color image-capturing element, and a blue color image-capturing element.

10. The image-capturing device according to claim 9, wherein one pixel is constituted by one image-capturing element unit and one second image-capturing element.

11. The image-capturing device according to claim 1, wherein one pixel is constituted by one image-capturing element unit and one second image-capturing element.

12. The image-capturing device according to claim 1 further comprising an illumination device for emitting the light in the second wavelength band.

13. The image-capturing device according to claim 12, wherein the light in the second wavelength band emitted by the illumination device includes multiple peak wavelengths.

14. A filter comprising a first region having an external shape in a circular or regular polygonal shape and a second region in a ring shape encircling the first region,
wherein the first region passes light in a first wavelength band and light in a second wavelength band which is different from the first wavelength band, and
in the second region, an optical transmittance rate of the light in the first wavelength band is lower than the optical transmittance rate of the light in the second wavelength band.

15. The filter according to claim 14, wherein from a portion of the second region at a border between the first region and the second region to an external periphery of the second region, the optical transmittance rate of the light in the first wavelength band gradually decreases.

16. The filter according to claim 14, which is made of an apodization filter.

17. The filter according to claim 14 wherein the size of the first region is variable.

18. A filter for passing light in a first wavelength band and light in a second wavelength band which is different from the first wavelength band,
wherein an optical transmittance rate of the light in the first wavelength band is lower than an optical transmittance rate of the light in the second wavelength band.

19. The filter according to claim 18,
wherein an average optical transmittance rate where the wavelength in the first wavelength band is equal to or more than 400 nm and less than 650 nm is more than 0% and equal to or less than 80%, and
an average optical transmittance rate in the second wavelength band is 80% or more.

20. The filter according to claim 18 made by laminating a red color transmission layer that is configured to transmit red color and a blue color transmission layer that is configured to transmit blue color.
